# EUROPÄISCHE PATENTSCHRIFT

(11) **EP 0 611 484 B1**
(45) Veröffentlichungstag und Bekanntmachung des Hinweises auf die Patenterteilung: **09.08.2000**
(21) Anmeldenummer: 92922739.5
(22) Anmeldetag: 04.11.1992
(51) Int. Cl.: H01L 21/265, H01L 21/36

(54) **VERFAHREN ZUR HERSTELLUNG EINER Si/FeSi2-HETEROSTRUKTUR**
PROCESS FOR PRODUCING A Si/FeSi2-HETEROSTRUCTURE
PROCEDE DE PRODUCTION D'UNE HETEROSTRUCTURE EN Si/FeSi2

(30) Priorität: 06.11.1991 DE 4136511
(43) Veröffentlichungstag der Anmeldung: 24.08.1994
(73) Patentinhaber: FORSCHUNGSZENTRUM JÜLICH GMBH, 52425 Jülich (DE)
(72) Erfinder: RADERMACHER, Klaus, D-5170 Kall-Benenberg (DE); MANTL, Siegfried, D-5170 Jülich (DE)
(86) Internationale Anmeldenummer: DE9200919
(87) Internationale Veröffentlichungsnummer: WO9309564

(56) Entgegenhaltungen:
- APPLIED PHYSICS LETTERS. Bd. 59, Nr. 17, 21. Oktober 1991, NEW YORK US Seiten 2145 - 2147 K. RADERMACHER ET AL. 'Ion beam synthesis of buried alpha-FeSi2 and beta-FeSi2 layers'
- APPLIED PHYSICS LETTERS. Bd. 59, Nr. 14, 30. September 1991, NEW YORK US Seiten 1737 - 1739 D. J. OOSTRA ET AL. 'Ion-beam synthesis of a Si/beta-FeSi2/Si heterostructure'
- JOURNAL OF APPLIED PHYSICS Bd. 58, Nr. 7, 1. Oktober 1985, NEW YORK Seiten 2696 - 2703 M. C. BOST ET AL. 'Optical properties of semiconducting iron disilicide thin films' in der Anmeldung erw{hnt
- MATERIALS RESEARCH SOCIETY SYMPOSIA PROCEEDINGS, SYMP. 86, VOL. 51 2. Dezember 1985, BOSTON, USA Seiten 439 - 444 F. H. SANCHEZ ET AL. 'Silicide formation by high dose transition metal implants into Si'
- MATERIALS SCIENCE AND ENGINEERING B Bd. B12, Nr. 1-2, 20. Januar 1992, LAUSANNE CH Seiten 115 - 118 K. RADERMACHER ET AL. 'Ion beam synthesis of buried epitaxial FeSi2'

## Beschreibung

Die Erfindung bezieht sich auf ein Verfahren zur Herstellung einer Silizium-Eisensilizid-(Si/FeSi₂)-Heterostruktur für ein elektronisches, optisches oder optoelektronisches Bauelement, insbesondere einen Permeable Base Transistor (PBT), einen Hetero-Bipolar-Transistor (HBT), einen Wellenleiter, einen Laser, einen Infrarot-Detektor oder eine Photodiode gemäß dem Oberbegriff des Anspruchs 1.

Der Elementhalbleiter Silizium zeichnet sich durch eine gute technologische Beherrschbarkeit gerade auch bei immer höher werdenden Integrationsdichte von Bauelementen aus. Aus physikalischen Gründen ist es aber in der Siliziumtechnologie nicht möglich, Bauelemente wie z.B. Photodioden oder Halbleiterlaser herzustellen. Insbesondere diese Bauelemente werden gegenwärtig auf der Basis von Verbindungshalbleitern wie z.B. Galiumarsenid GaAs oder Indiumphosphid InP hergestellt. Dabei hat man Epitaxieverfahren entwickelt, bei denen ternäre oder sogar quaternäre Legierungen des Typs AlₓGa₁₋ₓAs oder GaₓIn₁₋ₓAl_{y}P_{l-y} abgeschieden werden. Nachteilig bei diesen Verbindungshalbleitern ist die relativ geringe Integrationsdichte sowie die Umweltunverträglichkeit der Ausgangsstoffe.

Zur Herstellung optoelektronischer Komponenten auf Si-Basis wäre es physikalisch erforderlich im Silizium einen direkten Bandübergang zu erreichen. Zu diesem Zweck versucht man, z.B. nach R. Zachai et al "Photoluminescence in Short-Period Si/Ge Strained-Layer Super-lattice", Phys. Rev. Lett. 64 (1990), Seiten 1055-1058 durch das Wachstum von geeigneten Silizium-Germanium Übergittern ein "Falten" elektronischer Bänder zu erreichen. Um optoelektronische Komponenten in Silizium (Si) zu integrieren, versucht man z.B. nach P.N. Favenec et al. in "Optical Activation of Er⁺ Implanted in Silicon by Oxygen Impurities", Jap. J. Appl. Phys. 29 (1990), Seiten L524-L526 - gegenwärtig noch ohne Erfolg - laseraktive Ionen, wie z.B. Erbium in Silizium zu implantieren und Silizium als Wirtskristall für diese Ionen zu verwenden.

Aus optischen Absorptions- und elektronenspektroskopischen Messungen, z.B. aus M.C. Bost and J.E. Mahen, "Optical Properties of semiconducting iron disilicide thin films", J. Appl. Phys. 58 (1985), Seiten 2696-2703 oder A. Rizzi, H. Moritz and H. Lüth, "Electronic and vibrational properties of semiconducting crystalline FeSi₂ layers grown on Si(111)", J. Vac. Sci. Technol. A9 (1991), Seiten 912-916 deutet es sich an, daß das Material β-FeSi₂ sich elektronisch ähnlich wie die Verbindungshalbleiter verhält. Dabei kann FeSi₂ kristallin auf Silizium abgeschieden werden.

Das halbleitende β-FeSi₂ hat einen direkten Bandübergang mit einer Energie von ca. 0,85 eV, was einer Wellenlänge von 1,45 µm entspricht. Diese Wellenlänge liegt günstig in der Nähe des Adsorptionsminimum optischer Glasfaser von 1,55 µm. Weiterhin kann man die Energie des Bandüberganges über eine geeignete Dotierung in gewissen Grenzen einstellen. So führt eine Zugabe von Mangan zu einer Abnahme der Bandlücke mit zunehmender Mangankonzentration.

Neben der halbleitenden Phase des β-FeSi₂ existiert oberhalb einer Phasenumwandlungstemperatur Tᵤ von ungefähr 940°C die metallische α-FeSi₂-Phase die auch für elektronische Bauelemente von Bedeutung sein könnte.

In einem Vortrag während der Tagung "E-MRS 1991 Spring Meeting" vom 27. bis zum 31. Mai 1991 in Strasbourg (Frankreich) hat der Erfinder über wissenschaftliche Ergebnisse an vergrabenen epitaktischen FeSi₂-Schichten in Silizium-Substraten berichtet (veröffentlicht in Material Science and Engineering B, Band B 12, No 1-2, 20. Januar 1992, Seiten 115-118). Über die Herstellung solcher Strukturen wurde nur insofern berichtet, als daß man einer Implantation eines Si-Substrats mit Fe-Ionen zur Herstellung solcher Si/SiFe₂-Strukturen zwei Temperungen zunächst bei 1150°C für 10 sec und danach bei 800°C für 17 Stunden durchgeführt wurden. Insgesamt war auf Grundlage dieser unvollständigen Angaben ein Herstellungsverfahren nicht bekannt.

Aus Applied Physics Letters, Band 59, No. 17, 21. Oktober 1991, Seiten 2145-2147 ist als Stand der Technik ein Verfahren zur Herstellung einer Si/FeSi₂-Heterostruktur bekannt, wobei zunächst hochenergetische Fe-Ionen im Siliziumsubstrat implantiert werden, diese Struktur bei einer Temperatur von 1150°C für 10 s getempert wird, so daß eine kontinuierliche metallische α-FeSi₂-Schicht im Siliziumsubstrat entsteht; schließlich wird diese Si/FeSi₂ Heterostruktur bei einer Temperatur von 750°C für 20 Stunden getempert. Das beschriebene Verfahren ist jedoch nicht zur Schaffung einer Heterostruktur mit halbleitenden, schichtförmigen FeSi₂ geeignet.

Aufgabe der Erfindung ist ein Verfahren der eingangs bezeichneten Art, bei dem zur Ermöglichung der Integration optoelektronischer Bauelemente in die Siliziumtechnologie aus Silizium und halbleitendem FeSi₂ bestehende Heterostrukturen hergestellt werden können.

Diese Aufgabe wird durch ein Verfahren mit den Merkmalen a bis d gemäß Anspruch 1 gelöst.

Gemäß Anspruch 1 können Si/FeSi₂-Heterostrukturen mit Hilfe der Ionenstrahlsynthese nach diesem Verfahren hergestellt werden. Hierbei werden hochenergetische Fe-Ionen in Siliziumsubstrate implantiert. Mit Hilfe einer anschließenden -ersten- Temperung oberhalb der Umwandlungstemperatur Tᵤ des FeSi₂ erhält man eine kontinuierliche Schicht aus metallischem FeSi₂. Während dieser Temperung heilen auch die aufgrund der Implantation verursachten Gitterschäden im Si-Substrat aus.

Da die so entstandene metallische α-FeSi₂-Schicht in der Silizium-Matrix auch unterhalb der Phasenumwandlungstemperatur - insbesondere auch bei längerer Temperung - stabil ist, kommt dem gezielten Einbau zur Nukleation und/oder Wachstum vorgesehener Keime im Bereich dieser α-FeSi₂-Schicht entscheidende Bedeutung zu. Nur aufgrund dieser Maßnahme ermöglicht eine sich daran anschließende -zweite- Temperung unterhalb der Umwandlungstemperatur Tᵤ des FeSi₂ die Umwandlung der metallischen α-FeSi₂-Schicht in eine kontinuierliche, aus halbleitendem β-FeSi₂ bestehende Schicht.

Dabei ist es zur Keimbildung in der α-FeSi₂-Schicht vorteilhaft, in diese Schicht hochenergetische Fe-Ionen zu implantieren, die Ionendosis ist dabei möglichst gering, insbesondere unterhalb eines Wertes von 6 x 10¹⁴ Fe-Ionen pro cm² zu halten, sowie die Ionenplantation bei Temperaturen im Bereich von bis zu 300°C durchzuführen. Untersuchungen mit Hilfe der Transmissionselektronenmikroskopie zeigen im Ergebnis im Siliziumsubstrat vergrabene halbleitende β-FeSi₂-Schichten mit scharfen Grenzflächen.

Alternativ und vorteilhafterweise kann zur Keimbildung in der α-FeSi₂-Schicht eine selektive Amorphisierung dieser metallischen Schicht vorgenommen werden. Zweckmäßigerweise erreicht man diese selektive Amorphisierung mit Hilfe einer Ionenimplantation, insbesondere mit Dosis-Werten bis zu 6 x 10¹⁴ Fe-Ionen pro cm². Bei geeigneter Wahl der Implantationsparametern kann dadurch eine Amorphisierung der FeSi₂-Schicht erreicht werden, ohne dabei die Kristallstruktur der Siliziumdeckschicht vollständig zu zerstören.

Ein weiterer Vorteil der Maßnahme der selektiven Amorphisierung liegt darin, daß zur Rekristallisierung der FeSi₂-Schicht eine relativ sehr kurze Temperung bei Temperaturen unterhalb der Umwandlungstemperatur Tᵤ genügt, um halbleitende FeSi₂-Schicht zu bilden. Ein weiterer Vorteil liegt darin, daß gleichzeitig die Bildung einer epitaktischen Siliziumdeckschicht verbunden mit der halbleitenden β-FeSi₂-Schicht erfolgt. Diese Deckschicht kann als Substrat zu weiteren Epitaxieschritten mit Silizium verwendet werden.

Weitere vorteilhafte oder zweckmäßige Ausführungsformen enthalten die kennzeichnenden Merkmale der Ansprüche 4 bis 8. Insbesondere vorteilhaft ist die gemäß dem kennzeichnenden Merkmal des Anspruchs 4 bzw. 5 aufgeführte Maßnahme, Masken zwecks selektiver Ionenimplantation einzusetzen. Diese Maßnahme ermöglicht eine lateral unterschiedliche Verteilung einer oder mehrerer metallischen und/oder halbleitenden FeSi₂-Schichten im Siliziumsubstrat.

Mit Hilfe des erfingungsgemäßen Verfahrens hergestellte Bauelemente sind in den nachfolgenden Zeichnungen schematisch dargestellt und werden näher erläutert.

Es zeigen
- Figur 1: Si/FeSi₂-Heterostruktur mit lateraler Insitu Strukturierung des FeSi₂
- Figur 2a: p-n-Übergang mittels FeSi₂
- Figur 2b: p-n-Übergang mittels FeSi₂
- Figur 3: Struktur eines Halbleiterlasers auf der Basis FeSi₂
- Figur 4: Hetero-Bipolar-Transistor
- Figur 5: Mikroskopischer Querschnitt einer mit Hilfe des erfindungsgemäßen Verfahrens hergestellten Si/FeSi₂-Heterostruktur.

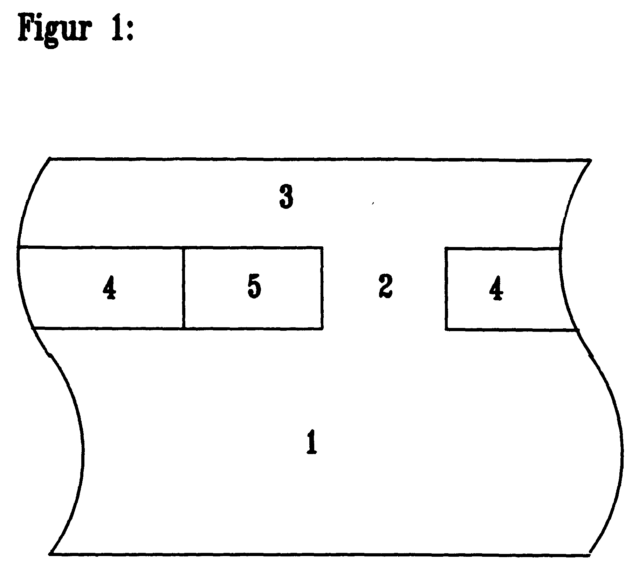

In der Figur 1 ist eine Si/FeSi₂-Heterostruktur mit lateraler in-situ-Strukturierung des FeSi₂ dargestellt. Diese Struktur läßt sich durch eine zweifache Implantation mit Hilfe jeweils unterschiedlicher Masken herstellen.

Zunächst wird mit Hilfe einer geeigneten Maske lateral begrenzt eine Implantation mit Fe-Ionen in das Siliciumsubstrat 1 vorgenommen. Die Fe-Ionen werden dabei nur dort, wo keine Maske das Eindringen der Ionen verhindert (hier: Bereiche 4 und 5), in das Siliziumsubstrat 1 eindringen. Anschließend wird die Maske samt darin enthaltenen Fe-Ionen entfernt. Während einer ersten Temperung oberhalb der Phasenumwandlungstemperatur Tᵤ zieht sich die Fe-Verteilung zu einer strukturiert vergrabenen, metallischen α-FeSi₂-Schicht zusammen (Bereiche 4 und 5). Zwischen diesen Strukturen befindet sich epitaktisches Silizium (Bereich 2), da aufgrund der Maskierung an dieser Stelle eine Implantation mit Fe-Ionen hier nicht stattgefunden hat. Zur Umwandlung eines Teilbereichs der so erhaltenen metallischen α-FeSi₂-Struktur ist eine weitere geeignete Maske sowie eine weitere Implantation zur Bildung von Nukleationskeimen für eine halbleitende β-FeSi₂-Struktur notwendig. Eine solche lateral begrenzte zweite Implantation mit z.B. Fe- oder Si-Ionen ist in Figur 1 im Bereich 5 geschehen. Nach Entfernen der Maske wurde mit Hilfe einer zweiten Temperung unterhalb Tᵤ im Bereich 5 der vorliegenden Si/FeSi₂-Heterostruktur halbleitendes β-FeSi₂ gebildet. Vorteilhafterweise liegt die nach dem erfindungsgemäßen Verfahren hergestellte FeSi₂-Schicht als vergrabene Struktur unterhalb einer epitaktischen Deckschicht aus Silicium vor, die als Substrat für weitere Epitaxieschritte dienen kann.

Des weiteren können mit Hilfe des erfindungsgemäßen Verfahrens auch folgende Bauelemente hergestellt werden:

### Anwendungsbeispiel 1: Photodiode

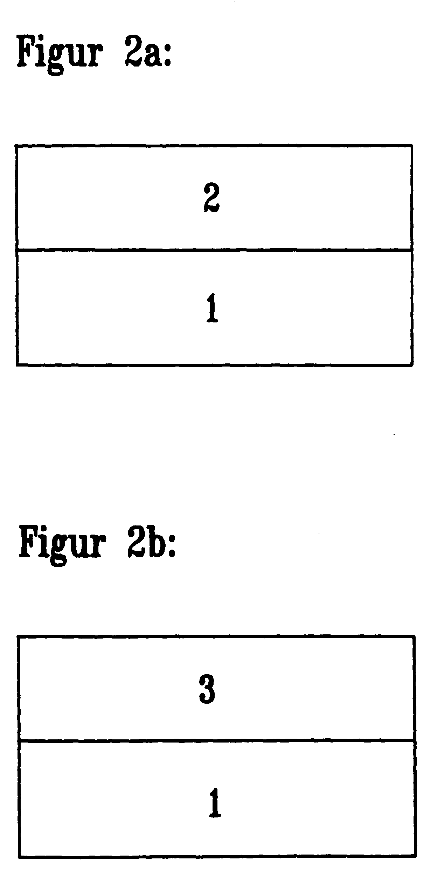

Damit die Energie, die ein Elektron bei einem Sprung vom Leitungsband zum Valenzband von halbleitendem β-FeSi₂ in Form eines Photons abgibt, ist zur Bildung einer Photodiode ein p-n-Übergang erforderlich. Ein solcher Übergang kann durch eine in Figur 2a dargestellte Schichtenfolge aus p-FeSi₂ als Schicht 1 und darauf gebildetem n-FeSi₂ als Schicht 2 gebildet werden. Dabei erfolgt die Dotierung des FeSi₂ durch geeignete Zugabe von Dotieratomen. Beispielsweise könnte zur Bildung des p-leitenden FeSi₂ Mangan oder Aluminium und zur Bildung des n-leitenden FeSi₂ beispielsweise Cobalt gewählt werden.

Eine alternative Möglichkeit zur Herstellung eines p-n-Übergangs liegt darin, eine Schichtenfolge herzustellen, die aus einer p-leitenden FeSi₂-Schicht 1 und einer darauf gebildeten n-leitenden Siliciumschicht 3 hergestellt ist. Des weiteren wäre auch die Kombination p-leitendes Silicium auf n-leitendem FeSi₂ denkbar.

Ein solcher p-n-Übergang ist schließlich noch in Durchlaßrichtung vorzuspannen, damit eine Photoquelle im Infraroten gegeben ist.

### Anwendungsbeispiel 2: Laserdiode

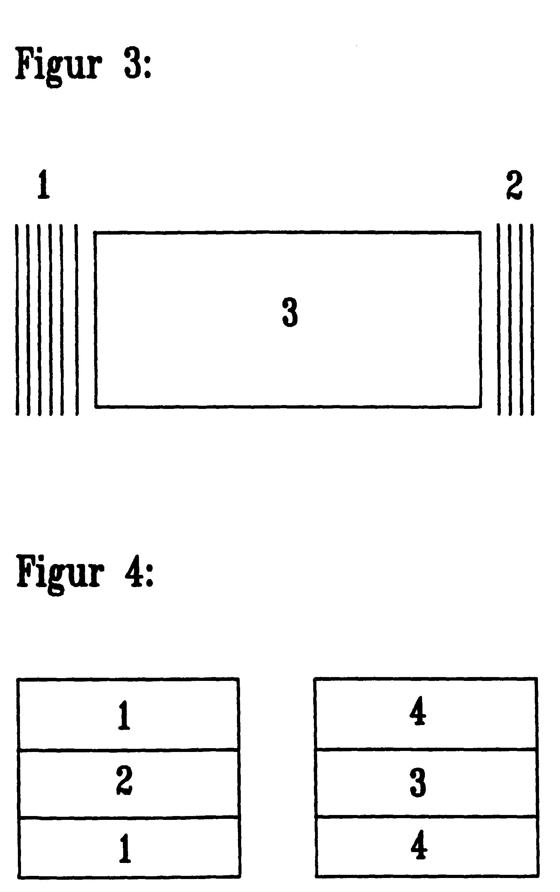

Die oben beschriebene Photodiode läßt sich beispielsweise durch Einbau in einen geeigneten Resonator zu einer Laserdiode umbauen. In Figur 3 ist die Struktur eines solchen Halbleiterlasers schematisch dargestellt. Die optisch aktive FeSi₂-Schicht 3 wird durch zwei geeignete Spiegel 1, 2 abgeschlossen. Diese Spiegel bestehen aus Reflektionsgittern, bei denen eine Brechungsindexänderung mit der Periode von 1/4 der Wellenlänge erzeugt wurde. Diese Spiegel können durch eine selektive Herstellung von metallischem α- und β-FeSi₂ gebildet werden. Auch die Implantation von geeigneten Ionen, die den Brechungsindex von halbleitendem FeSi₂ verändern, können mit Hilfe einer Implantationsmaske solcher Spiegel hergestellt werden. Die Form der optisch aktiven Schicht kann durch normale optische Lithographietechniken strukturiert werden. Bei der Verwendung der Ionenstrahlsynthese lassen sich solche Strukturen in einfacher Weise bei der Implantation durch geeignete Masken herstellen. Die Konzentration der Dotierstoffe (z.B. Mangan) in halbleitendem β-FeSi₂ kann so eingestellt werden, daß die Wellenlänge des Lasers gerade in das Absorptionsminimum von optischen Glasfasern fällt.

### Anwendungsbeispiel 3: Optischer Verstärker

Die beschriebene Photodiode läßt sich ebenfalls als optischer Verstärker verwenden. Dabei werden als Eingangssignal Photonen in dem Verstärker eingekoppelt. Daraufhin erzeugen sie im Verstärker durch induzierte Emission Übergänge von Elektronen vom Leitungsband in das Valenzband und verstärken die Intensität des Eingangssignals. Die Verstärkung kann durch die Länge des Verstärkers (mit Rücksicht darauf, daß die Verstärkung bei sehr geringen Eingangssignalen im wesentlichen exponentiell von der Länge des Verstärkers abhängt) und durch die anliegenden Strom-Spannungswerte in geeigneter Weise variiert werden. Ein solcher optischer Verstärker kann in optischen Glasfaserkabeln eingesetzt werden.

### Anwendungsbeispiel 4: Infrarotdetektor und Solarzelle

Bei der Absorption von Photonen haben sich Bauelemente auf Siliciumbasis bereits gut bewährt, wie z.B. die Solartechnologie auf Silicium zeigt. Eine Verbesserung hinsichtlich des Wirkungsgrades von Infrarotdetektoren könnte mit Hilfe von p-n-Übergängen aus halbleitendem β-FeSi₂ zu Silicium erreicht werden. Die oben aufgeführten Photodiodenstrukturen lassen sich bei einer Vorspannung in Sperrichtung auch als Detektoren von Photonen verwenden. Bei der Absorption von Photonen werden dann Elektronen vom Valenzband ins Leitungsband gehoben und als Strom nachgewiesen. Neben der für einen höheren Wirkungsgrad dieser Detektoren verantwortlichen Eigenschaft, daß der Bandübergang von FeSi₂ direkt ist, hat eine solche Heterostruktur zusätzlich den Vorteil eines fast atomar abrupten p-n-Überganges, was eine hohe elektrische Feldstärke im Übergang zur Folge hat. Damit werden durch Photoabsorption entstandene Elektron-Loch-Paare durch das elektrische Feld schneller getrennt und können nicht mehr rekombinieren. Auch dies führt bei Photodetektoren und insbesondere Solarzellen zu einer Erhöhung des Wirkungsgrades dieser Bauelemente.

### Anwendungsbeispiel 5: Wellenleiter in Silicium

Neben der Erzeugung und Detektion von Photonen ist für eine integrierte Optik in Silicium eine Führung der Photonen von einem Punkt zu einem anderen Punkt des Wafers von Bedeutung. Ein Bauelement, das die optische Information ohne Absorption und mit möglichst geringen Verlusten transportiert, ist der Wellenleiter. Auch hier bietet sich undotiertes halbleitendes FeSi₂ als mögliche Komponente zur Bildung eines Wellenleiters an. Dabei ist der große Brechungsindexsprung von FeSi₂ zu Silicium (Brechungsindex ungefähr 5,6 bzw. ungefähr 3,5) vorteilhaft für den Einsatz von FeSi₂ als Schichtwellenleiter in Silicium. Die Größe dieses Brechungsindexsprungs bildet eine gute Voraussetzung zur Führung von Photonen in Silicium. Insbesondere in Silicium vergrabene halbleitende FeSi₂-Schichtwellenleiter eignen sich besonders gut, da sich in diesem Falle oberhalb und unterhalb des Schichtwellenleiters ein Material mit gleichem Brechungsindex, nämlich Silicium, befindet. Es läßt sich abschätzen, daß die kritische Schichtdicke des Wellenleiters für eine geführte Ausbreitung einer Welle in der Größenordnung von etwa 100 nm und damit besonders klein ist. Darüber hinaus hat undotiertes FeSi₂ eine höhere Bandlücke als die optoelektronischen Bauelemente (Halbleiter, Laser und Photodetektor), mit der Folge, daß keine Elektronen vom Valenzband ins Leitungsband angeregt und somit nicht absorbiert werden können.

### Anwendungsbeispiel 6: Hetero-Bipolar-Transistor

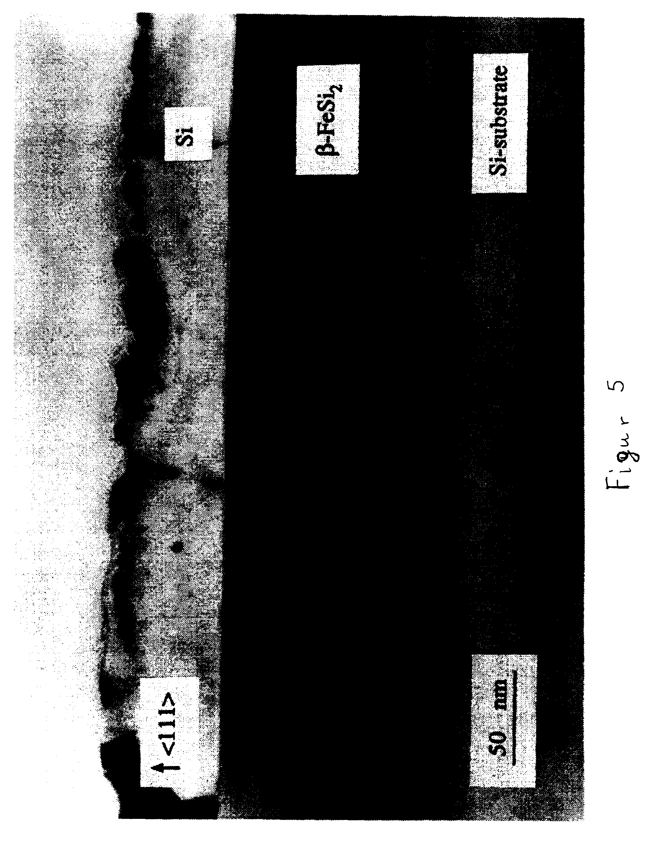

Die Grenzfrequenz und die Verstärkung eines Bipolar-Transistors kann deutlich gesteigert werden, wenn die Basis sehr dünn, mit einem abrupten Übergang und aus einem Material mit einer geringeren Bandlücke als Silicium hergestellt wird. Diese Hetero-Bipolar-Transistoren werden bereits schon mit einer Basis aus einem Silicium-Germanium-Mischkristall produziert. Da sich aber mit halbleitendem FeSi₂ sehr abrupte Übergänge in Silicium herstellen lassen und außerdem die Bandlücke von FeSi₂ geringer als die des Siliciums ist, kann die Basis eines Hetero-Bipolar-Transistors aus FeSi₂ aufgebaut werden und die Verstärkung und die Grenzfrequenz des Transistors erhöhen. In der Figur 4 ist schematisch ein n-p-n- und eine p-n-p-Transistor mit FeSi₂ als Basis dargestellt. Wahlweise kann p-FeSi₂ als Basis 2 oder n-FeSi₂ als Basis 3 ausgebildet werden. Dabei ist die Basis von als Emitter und Kollektor ausgestaltete Schichten aus n-Silicium bzw. p-Silicium umgeben (Emitter/Kollektor 1/1 bzw. 4/4).

### Anwendungsbeispiel 7: Permeable-Base-Transistor

Neben der halbleitenden β-FeSi₂-Phase ist die metallische α-Phase von FeSi₂ für die Anwendung als Basismaterial in einem Permeable-Base-Transistor interessant, da sich das FeSi₂ durch eine hohe Schottky-Barrierenhöhe von ungefähr 0,85 eV zu n-leitendem Silicium auszeichnet.

Im übrigen lassen sich durch eine Kombination dieser Einzelelemente für die Anwendung interessante Strukturen aufbauen.

In der Figur 5 ist ein mikroskopischer Querschnitt durch eine Silicium/β-FeSi₂-Heterostruktur, wie sie nach dem erfindungsgemäßen Verfahren hergestellt wurde, dargestellt. Deutlich ist die äußerst scharf begrenzte β-FeSi₂-Schicht mit einer Dicke von ca. 80 nm, benachbart von dem Si-Substrat auf der Unterseite und einer Si-Deckschicht auf der oberen Seite sichtbar.

## Patentansprüche

1. Verfahren zur Herstellung einer Silizium-Eisensilizid-(Si/FeSi₂)-Heterostruktur für ein elektronisches, optisches oder optoelektrisches Bauelement, insbesondere einen Hetero-Bipolar-Transistor, einen Wellenleiter, einen Laser, einen Infrarot-Detektor oder eine Photodiode, bei dem
a) zunächst hochenergetische Fe-Ionen im Siliziumsubstrat (4, 5) implantiert werden,
b) diese Struktur bei einer Temperatur oberhalb der Umwandlungstemperatur Tᵤ des FeSi₂ solange getempert wird, daß eine kontinuierliche, aus metallischem α-FeSi₂ bestehende Schicht (4, 5) im Siliziumsubstrat entsteht,
c) diese Si/FeSi₂-Heterostruktur unterhalb der Umwandlungstemperatur Tᵤ des FeSi₂ zur Bildung des halbleitenden FeSi₂ getempert wird,
**dadurch gekennzeichnet, daß**
d) zwischen den beiden genannten Temperschritten im Bereich der α-FeSi₂-Schicht (5) zur Nukleation und/oder Wachstum des halbleitenden FeSi₂ vorgesehene Keime mittels Ionenimplantation von Fe-Ionen gebildet werden.

2. Verfahren nach Anspruch 1,
**dadurch gekennzeichnet,**
**daß** die Ionenimplantation mit einer Ionendosis unterhalb eines Wertes von 6 x 10¹⁴ Fe-Ionen pro cm² Einsatz findet und bei Temperaturen bis zu 573 K (300 °C) durchgeführt wird.

3. Verfahren nach Anspruch 1,
**dadurch gekennzeichnet,**
**daß** die Ionenimplantation mit Dosis-Werten bis zu 6 x 10¹⁴ Fe-Ionen pro cm² und bei Temperaturen im Bereich von 4 K bis 373 K, insbesondere bei Raumtemperatur durchgeführt wird, so daß die α-FeSi₂-Schicht selektiv amorphisiert wird.

4. Verfahren nach Anspruch 1,
**dadurch gekennzeichnet,**
**daß** die Ionenimplantation im räumlichen Bereich der FeSi₂-Schicht (4, 5) selektiv, insbesondere räumlich begrenzt, eingesetzt wird.

5. Verfahren nach Anspruch 4,
**dadurch gekennzeichnet,**
**daß** zur selektiven Ionenimplantation Masken eingesetzt werden.

6. Verfahren nach Anspruch 1,
**dadurch gekennzeichnet,**
**daß** die Temperung der mit hochenergetischen Fe-Ionen dotierten Siliziumstruktur (1, 2, 3, 4, 5) bei einer Temperatur im Bereich zwischen 950°C und 1200°C, insbesondere bei 1150°C, durchgeführt wird.

7. Verfahren nach Anspruch 1,
**dadurch gekennzeichnet,**
**daß** die Temperung der mit hochenergetischen Fe-Ionen dotierten Siliziumstruktur (1, 2, 3, 4, 5) oberhalb der Umwandlungstemperatur Tᵤ des FeSi₂ im Zeitbereich von 0,5 sec bis zu 60 min, insbesondere 10 sec, erfolgt.

8. Verfahren nach einem der Ansprüche 1 bis 7,
**dadurch gekennzeichnet,**
**daß** die zur Bildung des halbleitenden FeSi₂ unterhalb der Umwandlungstemperatur Tᵤ des FeSi₂ stattfindende Temperung im zeitlichen Bereich von 1 sec bis zu 12 min, insbesondere 10 sec, erfolgt.

## Claims

1. Process for producing a silicon-ferrosilicon (Si/FeSi₂) heterostructure for an electronic, optical or optoelectronic module, more particularly a hetero-bipolar transistor, waveguide, laser, infra-red detector or photodiode, wherein
a) high-energy Fe ions are first of all implanted in the silicon substrate (4, 5),
b) this structure is tempered at a temperature above the transformation temperature Tᵤ of the FeSi₂ until a continuous layer (4, 5) consisting of metallic α-FeSi₂ is produced in the silicon substrate,
c) this Si/FeSi₂ heterostructure is tempered below the transformation temperature Tᵤ of the FeSi₂ to form the semiconducting FeSi₂,
characterised in that
d) between the two said tempering stages, nuclei destined for the nucleation and/or growth of the semiconducting FeSi₂ are formed in the region of the α-FeSi₂ layer (5) by means of the ion implantation of Fe ions.

2. Process according to claim 1,
characterised in that ion implantation is employed with an ion dosage below a level of 6 x 10¹⁴ Fe ions per cm² and is carried out at temperatures of up to 573 K (300 °C).

3. Process according to claim 1,
characterised in that ion implantation is carried out with dosage levels of up to 6 x 10¹⁴ Fe ions per cm² and at temperatures within the range 4 K to 373 K, more particularly at room temperature, thereby selectively rendering the α-FeSi₂ layer amorphous.

4. Process according to claim 1,
characterised in that the ion implantation is employed selectively, more particularly to a spatially limited extent, in the spatial zone of the FeSi₂ layer (4, 5).

5. Process according to claim 4,
characterised in that the selective ion implantation involves the use of masks.

6. Process according to claim 1,
characterised in that the tempering of the silicon structure (1, 2, 3, 4, 5) doped with high-energy Fe ions is carried out at a temperature in the range between 950°C and 1200°C, more particularly at 1150°C.

7. Process according to claim 1,
characterised in that the tempering of the silicon structure (1, 2, 3, 4, 5) doped with high-energy Fe ions takes place above the transformation temperature Tᵤ of the FeSi₂ in the time range from 0.5 second to 60 minutes, more particularly 10 seconds.

8. Process according to any of claims 1 to 7,
characterised in that the tempering which takes place below the transformation temperature Tᵤ of the FeSi₂ to form the semiconducting FeSi₂ is performed in the time range from 1 second to 12 minutes, more particularly 10 seconds.

## Revendications

1. Procédé de production d'une hétérostructure en silicium-siliciure de fer (Si/FeSi₂) pour un composant électronique, optique ou optoélectrique, notamment pour un transistor hétérobipolaire, un guide d'ondes, un laser, un détecteur à infrarouge ou une photodiode, qui consiste
a) à implanter d'abord des ions Fe de haute énergie dans le substrat (4, 5) en silicium,
b) à recuire cette structure à une température supérieure à la température Tᵤ de transition du FeSi₂ jusqu'à ce qu'il se forme une couche (4, 5) continue en FeSi₂-α-métallique dans le substrat en silicium,
c) à recuire cette hétérostructure en Si/FeSi₂ en dessous de la température Tᵤ de transition du FeSi₂ pour former le FeSi₂ semi-conducteur,
caractérisé en ce qu'il consiste
d) à former entre les deux stades de recuit mentionnés au moyen d'une implantation d'ions Fe dans la région de la couche (5) de FeSi₂-α des germes prévus pour la nucléation et/ou la croissance du FeSi₂ semi-conducteur.

2. Procédé suivant la revendication 1,
caractérisé en ce qu'il consiste
à effectuer l'implantation d'ions avec une dose d'ions inférieure à 6 x 10¹⁴ ions Fe par cm² et à des températures allant jusqu'à 573 K (300°C).

3. Procédé suivant la revendication 1,
caractérisé en ce qu'il consiste
à effectuer l'implantation d'ions avec des valeurs de dose allant jusqu'à 6 x 10¹⁴ ions Fe par cm² à des températures de l'ordre de 4 K à 373 K, notamment à la température ambiante de manière à rendre sélectivement amorphe la couche de FeSi₂-α.

4. Procédé suivant la revendication 1,
caractérisé en ce qu'il consiste
à utiliser l'implantation d'ions de manière sélective, notamment de manière limitée dans l'espace, dans une zone spatiale de la couche (4, 5) de FeSi₂.

5. Procédé suivant la revendication 4,
caractérisé en ce qu'il consiste
à utiliser des masques pour l'implantation sélective d'ions.

6. Procédé suivant la revendication 1,
caractérisé en ce qu'il consiste
à effectuer le recuit de la structure (1, 2, 3, 4, 5) dopée par des ions Fe de grande énergie à une température comprise entre 950°C et 1200°C, et notamment à 1150°C.

7. Procédé suivant la revendication 1,
caractérisé en ce qu'il consiste
à effectuer le recuit de la structure (1, 2, 3, 4, 5) en silicium dopée par des ions Fe de grande énergie au dessus de la température Tᵤ de transition du FeSi₂ dans un intervalle de temps de 0,5 seconde à 60 minutes, notamment pendant 10 secondes.

8. Procédé suivant l'une des revendications 1 à 7,
caractérisé en ce qu'il consiste
à effectuer, le recuit se produisant, pour la formation du FeSi₂ semi-conducteur, en dessous de la température Tᵤ de transition du FeSi₂, dans un intervalle de temps de 1 seconde à 12 minutes et notamment pendant 10 secondes.
